# EUROPEAN PATENT SPECIFICATION

(11) **EP 2 625 938 B1**
(45) Date of publication and mention of the grant of the patent: **21.03.2018**
(21) Application number: 11768126.2
(22) Date of filing: 06.09.2011
(51) Int. Cl.: H05K 7/14, H05K 7/20

(54) **POWER ELECTRONIC VEHICLE COMPONENT**
LEISTUNGSELEKTRONISCHE FAHRZEUGKOMPONENTE
COMPOSANT ÉLECTRONIQUE DE PUISSANCE POUR VÉHICULE

(30) Priority: 04.10.2010 US 389599 P; 04.10.2010 EP 10186461
(43) Date of publication of application: 14.08.2013
(73) Proprietor: BRUSA Elektronik AG, 9466 Sennwald (CH)
(72) Inventor: KRAUSE, Axel, CH-9650 Nesslau (CH)
(74) Representative: Rösler, Frank
(86) International application number: PCT/IB2011/053894
(87) International publication number: WO 2012/046153

(56) References cited:
- EP-A2- 2 107 864
- DE-A1-102006 025 453
- JP-A- 2004 236 429
- US-A1- 2010 072 865
- US-B1- 6 320 776

## Description

The invention relates to a power electronic vehicle component, such as an on-board charging device, a converter or a voltage converter for electric or hybrid vehicles, having a housing accommodating at least one power electronic component, in particular an inductive component such as a coil, choke or transformer and at least one printed circuit board electrically communicating with the power electronic component.

The invention also relates to an electric or hybrid vehicle which comprises such a vehicle component.

In modern power electronics the designer is faced again and again with similar tasks. In particular, for mobile applications, power modules, chokes, transformers and capacitors must be electrically and mechanically connected together in such a manner that the requirements for reliable contacting, vibration-proof construction, simple and space-saving assembly, lowest possible weight and good cooling are satisfied.

There is a range of standard solutions for the electrical connection of power modules to capacitors. In most applications, the connection is effected via a circuit board, wherein the capacitors are soldered or screwed onto the circuit board and the power modules are also soldered or pressed in. The entire unit is screwed onto a heat-sink, so that the heat produced by the power modules is optimally dissipated.

Larger inductive components (chokes, transformers) are excluded from this assembly technique however, since they are usually so heavy (e.g. over 1kg) that they cannot be directly soldered onto the circuit board. In contrast to the markedly lighter capacitors, inductive components also produce considerable waste heat, which, in the best case, is fed directly into the heat-sink on which the power modules are already located. In this context, it has proved useful, for example, to cast the inductive component directly into a recess in the heat-sink with a thermally conductive casting compound. This satisfies the requirement for vibration-proof construction with optimal heat dissipation, but it still does not produce an electrical connection to the circuit board described above.

A further complication is the fact that the windings of the transformer and chokes are formed with HF stranded wires. The insulation of the stranded wires, constructed from many single wires, can be removed by tin plating, so that a good contact site is produced. In the assembly process the wound components are cast in the housing first, then the circuit boards are mounted. The direct soldering of the tin-plated winding contacts in the device would certainly be possible, but in the context of quality requirements for cars in particular, it is not considered a reliable process.

As another possibility for providing the contacting, the stranded wire being soldered to plug-in contacts, which are then fixed onto the housing (electrically insulated). The mating counterpart is already soldered in the circuit board at the correct place, so that when the circuit board is placed on top, a reliable contact is made. This method has been proven in practice, but requires additional plug-in contacts.

Another important aspect in the automotive field relates to the connection between circuit boards and power modules. Here also, an optimal approach must be found with regard to weight minimisation (fewest possible components), space optimisation (smallest possible components, space-saving arrangement), temperature optimisation (lowest possible waste heat, efficient cooling) and large lot sizes. The latter aspect requires as high a degree of automation as possible in production.

Approaches to solutions proposed in the prior art are presented below:

Prior document US-20090154101A discloses a converter arrangement with a housing and a substrate arranged therein, on which converter switches are fixed, and a printed circuit board. The converter is cooled with liquid and is intended for use in an electric car.

The electrical connection between the printed circuit board and the substrate is made via a plurality of spring pins. This connection serves to transmit control signals for the switches of the substrate. In the assembled condition the spring pins are pressed between the printed devices to be connected and thus form the electrical contact.

The converter arrangement comprises a jet array, in order to direct the cooling liquid over the converter switches and the substrate. The electrical connection between the printed circuit board and the substrate is effected through this jet array. Guide channels are provided for this purpose. This means that the spring pins penetrate the jet array filled with cooling liquid.

An arrangement of this type has a complicated and space-consuming construction, wherein furthermore the contacting by means of spring pins through an intermediate layer filled with cooling liquid requires enormous precision during production and assembly. The electrical connection by means of spring pins is itself susceptible to vibrations due to its construction, and therefore not trouble-free. Particular disadvantages with regard to the weight are caused by the jet array inside the housing and the device for collecting the cooling liquid.

EP 1 428 419 B1 discloses an actively externally cooled housing with a power-loss heat generating electronics module. The electronics module is placed on a side wall of the housing, by means of which the heat can be dissipated. A ventilator unit is provided outside the housing for this purpose. On an outer side of the housing a plug and socket combination can be seen for the electronic connection of the ventilator unit. This arrangement does not involve a vehicle component, and neither does this document contain any teaching about the connections between electrical modules inside the housing.

US 2009/0021971 A1 discloses a converter arrangement for a vehicle, having a housing and three converters. This document is mainly concerned with the arrangement of a cooling loop in a U-shape, on the outer side of which power modules are placed. How these power modules are connected together and to other components remains open. It is a fact however that the cooling loop has a negative effect on the weight and space requirements, which leads to increased production and operating costs, in particular when it is used in vehicles.

WO 95/01088 A1 discloses a converter module with a metal housing, the front and top faces of which are each designed as a cooling channel plate, on which the circuit components are mounted. This document provides no teaching about the arrangement and connection of electronic components inside the housing.

EP 1363026 A2 discloses a motor for a vehicle with an integrated converter. Transistor modules, from which contact arms project upwards, are placed directly on the engine housing. Above these transistor modules sits a board with supply leads embedded in resin. Above this sits a printed circuit board. The connection to the MOS transistor modules lying underneath is effected via an intermediate board and via contact pins projecting from this board. After the printed circuit board is placed on top, these are soldered to it.

In this document a type of sandwich structure with increased packing density is disclosed. The soldering of connections however involves increased cost and an additional, error-prone process step. At the same time the increased packing density causes a sharply increased concentration of heat, which can only be inadequately dissipated with the present cooling system.

Below, prior art which deals with a connection between printed circuit boards is discussed.

The internet site www.phoenixcontact.de/leiterplattenanschluss/226_51579.htm (bottom of page) discloses a plug connector component which connects two circuit boards together. Such a connection requires an additional component, namely the plug connector between the printed circuit boards, which has an adverse effect on weight, space requirements, assembly effort and costs.

FR 2693340A1 discloses a rectangular arrangement of printed circuit boards, which can be connected together via a rectangular intermediate piece - i.e. without cables. As in the previous document this arrangement contains an intermediate part, besides which there would be no space for a rectangular arrangement of this type in a compact designed and commercially competitive vehicle component.

EP 1978600B1 discloses a circuit board arrangement in which two or more circuit boards are connected together via fixed plug connectors. The plug connectors themselves have a planar construction and overlap with neighbouring circuit boards. For example, one circuit board can be a circuit board for power electronics and the other circuit board can be a signal electronics circuit board. An application in a power distributor box or BCU (Body Controller Unit) in powered vehicles is mentioned.

Instead of a simple plug connector, a fuse holder can also be plugged in between two circuit boards and there provide both a mechanical and an electrical connection between the circuit boards, wherein it accommodates one or more electrical fuses at the same time.

In this arrangement also an additional plug connector is necessary, so that here also the same disadvantages occur as in the case of the previous documents.

DE 10 2005061166 A1 discloses circuit board plug and socket connections and is concerned in particular with a precise guiding of contacts by the use of pressure springs. Other than a spatial arrangement of the circuit boards to be connected, nothing can be found in this document in regard to space, weight or cost savings.

DE 10031678 A1 discloses a power module with a housing. Contact pins are fixed in the base of the housing. A substrate with semiconductor elements forming a control circuit is pressed to the contact pins. The other ends of the contact pins are connected via leads with semiconductor chips on a metal plate. DE 10 031 678 A1 does not relate to electric vehicles. The heat produced in the semiconductor chip is not comparable to the heat produced by an inductive power element. Thus, the assembly disclosed therein would not help to solve the problems arising in a vehicle power component.

EP 2107864 A2 discloses a control device comprising a board, a sub-module and a housing cover. The connector parts being pressed into the circuit board extend from a housing of a sub-module. The housing of the sub-module is not the common housing, in which all components are accommodated. A simple, space-saving and heat-removing connection is not possible according to the teaching of his publication.

US 6320776B1 relates to a power drive apparatus comprising a main circuit board which is connected with a filter substrate. The filter substrate is accommodated in a housing having openings for receiving switching terminals of the circuit board. All of the above described assemblies are not efficiently space-saving and are not suitable for use in electronic vehicles.

DE 10 2006 025453 A1 does not relate to electronic vehicles and discloses a press-fit module and a semiconductor press-fit module. The assemblies comprising semiconductor circuits are connected by means of PCB structures.

JP-2004-236429 A discloses an electrical apparatus for a vehicle having a boosting coil of a switching converter. For radiating the heat from the coil to the outside the boosting coil is stored in a recessed portion formed on an aluminium plate which is filled with an impregnant for transferring heat to the aluminium. JP 2004 236429 A does not relate to a simple and space-saving connection of the coil with a printed circuit board.

US 20100072865 A discloses a vehicle device including a motor generator, a power control unit and a case. The publication does not give any teaching of how to efficiently and space-saving connecting a power module and a printed circuit board electrically. US-B1-63320776 discloses a connector according to the preamble of claim 1.

The object of the invention consists of eliminating the above described disadvantages and providing a power electronics vehicle component, which is characterized by a more reliable electrical contacting between the individual components, lower space requirements, higher weight savings and simpler assembly. The cooling of heat generating components is to be effected in a particularly efficient and direct manner. In regard to this optimisation the production and operating costs of the power electronics vehicle component, and therefore of the vehicle overall, should also turn out to be lower than with known solutions.

This object is achieved with a power electronic vehicle component according to claim 1, of the type given at the beginning by the fact that the printed circuit board is electrically connected to the power electronics component via at least one plug connection, which is formed by connector parts of male and female type that are pressed into one another and form a press-fit connection, wherein one of the connector parts is fixed to the housing, which is preferably liquid cooled, and in which the power electronics component and the printed circuit board are accommodated and connected to the power electronics component via a connection cable.

Instead of the term "power electronic vehicle component" also the equivalent term "vehicle component comprising power electronics" may be used.

The term, that the connector parts of male and female type can be pressed into one another, is to be understood as indicating that the connector parts may be pressed into one another with low pressure or with high pressure and/or forming a press-fit connection.

The printed circuit board and the power electronics component communicate with each other here by means of a detachable connection that is simple to produce. On the printed circuit board side the connection cables are completely eliminated, meaning that space and weight savings can be made. The direct insertion of the printed circuit board by pressing into the connector part(s) fixed onto the housing also results in a high mechanical stability of the arrangement.

These coordinated measures produce an optimised arrangement in which the printed circuit board can be simply and reliably electrically connected to the power module, wherein an efficient dissipation of heat can be achieved by the arrangement of the other connector part directly on the housing wall. The heat that loads the connector part due to the power electronics component is introduced directly into the housing wall. Here the plug connection is cooled by the direct coupling to the housing, so that the waste heat from the plug connection, and partly also that of the circuit board, can be dissipated to the housing. Furthermore, by means of the connection according to the invention, a compact space-saving construction is produced. During assembly, the printed circuit board only needs to be pressed down from above, that is, perpendicular to the printed circuit board, into the connector parts, for example in the form of connector strips, arranged or fixed underneath it. Such a press-fit connection requires only a single, short and straightforward process step. Press-fit insertion to produce contact connections is considerably better than soldering and is also preferred as such by the automotive industry. A detachable connection exists, and one which involves a simpler process step, wherein the vibration resistance and mechanical stability increase in equal measure. The latter properties are very important criteria in the vehicle industry in particular for use in batch production.

An advantage here is the simplified mounting of the printed circuit board: it is well known that it is not easy to work under the printed circuit board, since the printed circuit board and power electronics component are accommodated in a housing that is preferably water-cooled. Instead of a complicated soldering process, according to the invention only the printed circuit board connector parts need to be inserted or pressed into the connector parts arranged underneath on the housing. Facing the connector strip, diametrically opposed pins are soldered onto the printed circuit board that communicate with the connector strip.

The terminals of an inductive power electronics component, such as transformers or a choke, usually need to be connected to a printed circuit board, and this in turn to a large capacitor and the drive circuit. To do this, the tin-plated HF stranded wires of the inductive component are soldered into a small connector part. This connector part contains plated-through bores (identical to female connector parts) for receiving press-in contacts. In the printed circuit board these press-in contacts are arranged as male connector parts. The printed circuit board normally contains link capacitors and driver connections. A detachable connection that is secure to process is thus obtained between the inductive component and the printed circuit board.

Here the terminals of the power electronics component, for example of the transformer or the choke, are connected to a connector part. The connector part is directly mounted on the housing wall or on the base of the housing. The waste heat from the plug-in devices and the printed circuit board is dissipated onto the housing by means of the direct contact of the plug part with the housing. The additional inductance of a supply lead cable barely has any effect.

The term "power electronic vehicle component" is to be understood as a component that contains power electronics, but which moreover can also comprise control electronics (e.g. driver circuits) for controlling the power electronics and therefore serves to provide the appropriate electrical power (voltage, current). This can take the form of, for example, a charging device for charging up a vehicle battery, a converter for generating an AC voltage for the drive unit of a motor or a voltage converter for supplying other devices, such as radio, GPS, air conditioning unit, heating, lights, etc.

The term "power module" is understood to mean a unit containing power electronics, in particular electronic switches such as IGBTs (Insulated gate bipolar transistors), MOSFETs, diodes, but also capacitors etc., and which in some cases is driven by a set of control electronics. The power module itself can be accommodated in a separate housing or be placed on a separate circuit board. In general, and especially in the automotive field, the power module generates large amounts of waste heat.

The term "power electronics component" is understood to mean a component separate from the power module, that also processes electrical power, in particular an inductive component, such as a coil, choke or transformer. The power electronics component is also characterized by increased amounts of waste heat.

Reference in this specification to "one embodiment" or "an embodiment" means that a particular feature, structure, or characteristic described in connection with the embodiment is included in at least one embodiment of the disclosure. The appearances of the phrase "in an/one embodiment" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not other embodiments.

In one embodiment the male connector part is essentially perpendicular to the plane of the printed circuit board. This not only produces a higher packing density, but also allows a simpler installation into the housing from above.

In one embodiment the housing is liquid cooled (e.g. with water, oil, etc.). This guarantees a particularly efficient cooling of the power electronics component and all other parts fixed to the housing, such as, for example, connector parts and, where appropriate, other power electronics components.

In one embodiment the connector part seated directly on the printed circuit board is of male type.

In one embodiment the connector part is glued or screwed onto the housing, which results not only in a mechanically rigid, but also a good thermal coupling to the housing.

In one embodiment the plug connection is made in the form of connector strips which comprise multiple contacts. This results in a simpler assembly and a more stable mechanical connection.

In one embodiment the power electronics component is fixed onto the housing. This causes a direct feeding of the waste heat into the housing.

In one embodiment the power electronics component sits in a cut-out with side walls that project into the interior of the housing and is preferably glued into it, which means the thermal coupling to the housing is further improved.

In one embodiment the power electronics component is accommodated in a pocket formed integrally with the housing and is preferably embedded in the pocket with glue. This allows for an efficient mechanical and thermal mounting of the component. In connection with the inventive plug mechanism a space-saving arrangement is achieved, the assembly of which is simple and cost-effective.

In one embodiment the power electronics component is seated on the same wall of the housing as the connector part. This facilitates both short cable feeds and a simultaneous coupling to the wall of the housing that is best cooled.

In one embodiment the printed circuit board is electrically connected to a power module via at least one plug connection, which is formed by connector parts of male and female type that can be pressed into one another, wherein one of the connector parts sits directly on the printed circuit board and the other connector part sits directly on the power module.

Printed circuit board and power module are here directly plugged into one another, which means that connection cables are no longer necessary and thus space and weight can be saved. The gap between printed circuit board and power module is minimal, so that a high packing density is obtained. The direct insertion by pressing also results in a high mechanical stability of the arrangement.

In one embodiment the power module comprises electronic switches, such as IGBT's, MOSFET's and/or diodes. The power module here consists of multiple components, is used for switching the power current, for example to set it high or low, conversion, etc., and is sometimes also referred to as a switching module.

In one embodiment the printed circuit board is electrically connected to a further electronic element, which is accommodated in the housing, via at least one plug connection, which is formed by connector parts of male and female type that can be pressed into one another, wherein one of the connector parts sits directly on the printed circuit board.

The further electronic element is accommodated in the same housing and may be a power module, a further power electronics component or any other electronic power component. The advantage of this embodiment is the simplicity of connecting at least two power electronic elements by means of a printed circuit board. The printed circuit board has as the same time two functions, namely to build an electronic circuit with the power electronic component and to make an electrical connection between the power electronic component and the further electronic element.

In an embodiment the further electronic element is a power module, and the other connector part of the plug connection, which connects the printed circuit board and the power module, sits directly on the power module.

In an embodiment the power module is fixed to the housing, preferably abutting thereto in a planar manner, for efficiently conducting heat to the housing.

In an embodiment the further electronic element is a further power electronics component, and the other connector part of the plug connection, which connects the printed circuit board and the further power electronics component, is fixed to the housing and connected to the further power electronics component via a connection cable. !n this way, two or more power electronics components may be connected to a printed circuit board and at the same time connected with each other via the printed circuit board.

In an embodiment at least one power electronics component is an inductive component, such as a coil, choke or transformer. Inductive components in vehicle drive applications are heavy components, which are firmly and permanently mounted in the housing. In order to guarantee a simple, efficient and detachable connection to a printed circuit board the inventive solution uses plug connections.

In an embodiment the strand of the power electronics component is used as connection cable connecting the power electronics component with the connector part. The strand from which the inductive part is build up is also used as connection cable thus avoiding additional connection leads. An advantage is, that the strands are already isolated.

In an embodiment the power electronics components are spaced from one another. Thus, the heat production is uniformly distributed over the housing.

In an embodiment the connector parts of the power electronics components are spaced from one another. The heat of the connector parts may be conducted more efficiently into the housing. The mechanical stability of the printed circuit board pressed into these connector parts (which are spaced apart of each other) is increased.

In one embodiment at least two printed circuit boards are provided, which electrically communicate with the power module and border one another to the side and each of which partially overlaps with the power module, the printed circuit boards preferably lying in the same plane. Both printed circuit boards are connected to the power module in the same manner, that is, pressed directly into the latter via the plug connection. Consequently, two printed circuit boards with different functionality can be connected to the same power module. The arrangement of the printed circuit boards in the same plane guarantees a compact space-saving design. A great advantage of this embodiment lies the fact that no separate connection element, which otherwise has no additional function, is required for the connection between the two printed circuit boards, but rather a component (power module) is exploited, which already has an inherent important function in itself. This results in a considerable reduction in components.

In one embodiment the contours of the printed circuit boards lying above the power module and its immediate edge region each have a profile that deviates from a straight line, preferably a profile with at least one bend or one curve, preferably of essentially 90°, wherein the surfaces of the printed circuit boards lying above the power module and its immediate edge region are essentially complementary to each other. By means of this and the two special embodiments discussed below, the two printed circuit boards can cover the plug pin assignment on the power module, so that the contact points of each of the two printed circuit boards, distributed for example around the periphery, can be reached/contacted in accordance with the wiring requirements.

In preferred embodiments, one of the printed circuit boards has an L-shape or a modified U-shape, in which one of the arms is shorter than the other. In one embodiment, the power module is fixed onto the housing, preferably abutting it in a planar manner. This causes a direct feeding of the waste heat into the housing.

Further aspects of the invention are indicated in the Figures and in the appended dependent claims.

The list of reference marks forms part of the disclosure.

With reference to the Figures of drawings, versions of the invention will now be explained in more detail by means of symbols and examples.

The Figures will be described in combination and taken as a whole. Equivalent reference marks indicate identical components, and reference marks with different indices indicate functionally equivalent or similar components.

In the drawings:
Fig.1 shows a prior art power electronic vehicle component in a schematic view
Fig.2 shows a detail of a vehicle component of prior art construction with the housing open from above,
Fig.3 shows the vehicle component of Fig. 2 along section A-A,
Fig.4 shows a variant of the invention,
Fig.5 shows a further variant with a combination of contact mechanisms according to the invention.

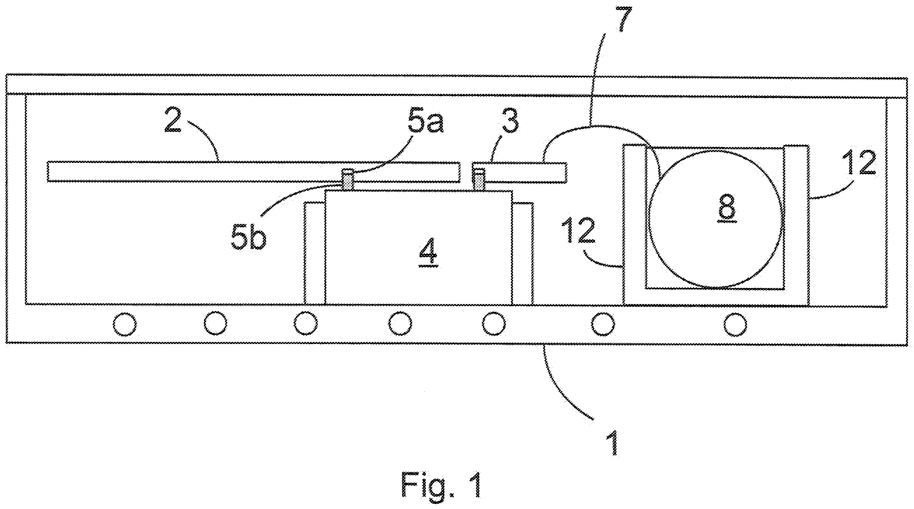

Figure 1 shows a power electronic vehicle component in a schematic view. In a housing 1 of the vehicle component a power module 4, a printed circuit board 2, a further printed circuit board 3 and a separately arranged power electronics component 8, for example an inductive component, such as a coil, transformer or similar, are accommodated. The printed circuit board 2 is populated with control electronics, driver circuits and capacitors and serves to control the power module 4, to which it is connected via a plug connection 5. The plug connection 5 includes a connector part 5a assigned to the printed circuit board 2 and a connector part 5b assigned to the power module 4. One of the connector parts, here 5a, sits directly on the printed circuit board 2, the other connector part 5b directly on the power module 4. The connector parts 5a, 5b, one being of male, the other of female type, are pressed into one another and form a press-fit connection. The male connector part is essentially perpendicular to the plane of the printed circuit board. The plug direction therefore is also perpendicular to the printed circuit board. During the assembly, the printed circuit board 2 is pressed onto the power module 4 from above, which produces an electrical, and at the same time also a mechanical, connection between the power module 4 and the printed circuit board 2. The pressing of the two connector parts 5a, 5b into each other guarantees a reliable, vibration-proof and trouble-free electrical connection.

It is irrelevant on which component the male connector part or female connector part respectively is arranged, however it has proved advantageous when the male connector part sits on the power module 4 and the female connector part on the printed circuit board 2.

In the embodiment of Fig. 1 a second printed circuit board 3 is also connected to the power module 4 via a plug connection 5 of the same type. It serves to electrically connect the power module 4 to a further power electronics component 8. For this purpose, connection leads 7, leading to the power electronics component 8, are fixed, preferably soldered, onto the printed circuit board 3. To connect the power electronics component 8 during assembly, all that is necessary is for the printed circuit board 3 to be plugged or pressed into the power module 4 from above. Apart from the connections to the connection leads 7, other components, for example capacitors, can be soldered onto the circuit board 3.

The housing 1 is preferably liquid cooled, as is indicated by the round liquid channels in the base of the housing 1. The heat that is produced mainly in the power module 4 and also in the other power electronics component 8 can be thereby efficiently dissipated. The power module 4 is consequently also directly mounted on the housing 1. Due to its planar construction, it is in contact with the housing over its whole surface, which means the heat is dissipated essentially downwards. To the side of the power electronics component 8, side walls 12 projecting from the housing wall into the interior of the housing form a cut-out, in which the power electronics component 8 is embedded, preferably with an adhesive of high thermal conductivity. An enclosure and embedding of this type is in particular suitable for inductive components, since these are inherently nonplanar.

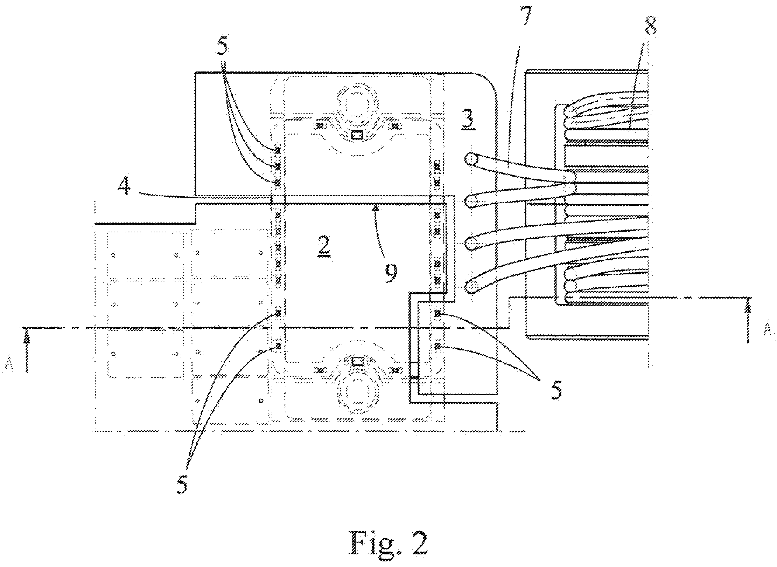

Figure 2 shows a detailed view of the arrangement in a vehicle component from above. The two printed circuit boards 2, 3 each overlap with the power module 4 (shown as transparent in dashed lines), border each other laterally in the region above the power module 4 and between them form a small gap 9. The printed circuit boards 2, 3 lie essentially in the same plane and are shaped in the manner of matching puzzle parts.

The contours of the printed circuit boards 2, 3 that lie above the power module 4 and its immediate edge region each have a profile that deviates from a straight line. In the example illustrated, the contours of the printed circuit boards 2, 3 or more comprise bends with a bending angle of essentially 90°, wherein the surfaces of the printed circuit boards 2, 3 that lie above the power module 4 and its immediate edge region are complementary to each other. The printed circuit board 3 has, broadly speaking, an L-shape, which when considered in more detail is seen to be a modified U-shape, in which one of the arms is shorter than the other. By means of this geometrical design the connector parts 5b distributed over the top in the edge region of the power module 4 are contacted by the printed circuit board 3 and also by the printed circuit board 2 in equal measure. The special geometrical design of the printed circuit boards 2, 3 overlapping with the power module 4 depends on the plug pin assignment, however the embodiment illustrated is also proven in relation to the mechanical stability of the connection. Instead of bends in the side contours, curves can also be provided.

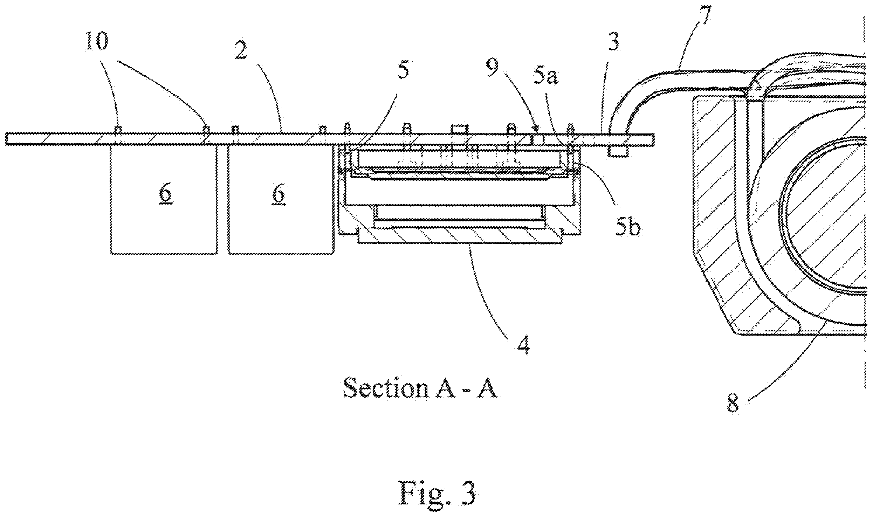

Figure 3 shows the arrangement of Fig. 2 along section A-A. The plug connections 5 form between the printed circuit boards 2, 3 and the power module 4 a compact and reliable, space and weight saving connection. The printed circuit boards 2, 3 are in this arrangement immediately adjacent to the power module 4 from above. The printed circuit board 2 can also be populated with electronic components 6, which generate a non-negligible amount of heat and have some space requirements. These electronic components 6 are fixed to the underside of the printed circuit board 2 and are therefore located at the level of the power module 4. The fixing of the components 6 is preferably implemented by solder connections 10. The soldering of the components 6 into the printed circuit board 2 guarantees a reliable electrical and mechanical coupling. At the same time, these heat-generating electronic components 6 are directed downwards, that is, directly facing towards the cooled housing wall.
The printed circuit board 3 can also be populated with small and light electronic components, preferably in SMD (surface mounted device) technology.

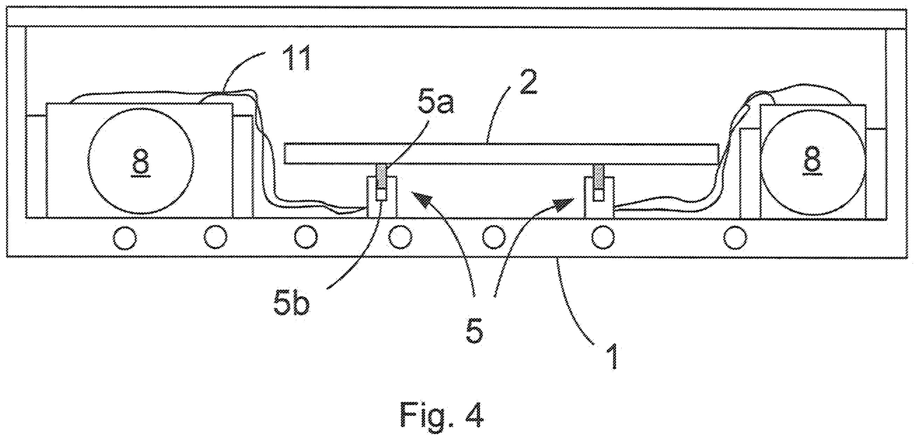

Figure 4 shows now the contacting option according to the invention, namely between the printed circuit board 2 and a power electronics component 8, in which one of the connector parts 5b is internally fixed to the housing 1, for example by means of adhesive or screws. The connector part 5b is connected with a connection cable 11 to an inductive power electronics component 8, for example a coil, choke or transformer. As in the previous example, during assembly the printed circuit board 2 is pressed with its connector parts 5a into the connector parts 5b perpendicularly from above. In addition to providing the simple and space-saving assembly, such an embodiment also facilitates the thermal decoupling of power electronics component 8 and printed circuit board 2, since the connector parts 5b in contact with the housing 1 are themselves cooled, because the heat transferred onto it can be emitted directly onto the housing 1. The plug connection 5 between printed circuit board 2 and power electronics component 8 facilitates a simple assembly and space-saving design.

In the embodiment of Fig. 4 at least two power electronics components 8 are accommodated in the housing 1 and each power electronics component 8 is connected to a separate connector part 5b via a connection cable 11. The connector parts are both fixed to the housing 1. The printed circuit board 2 is electrically connected to each power electronics component 8 via connector parts 5a sitting directly on the printed circuit board 2. The connector parts 5a of the printed circuit board 2 and the connector parts 5b of the power electronics components 8 are of male and female type and can be pressed into one another and form plug connections 5.

The features described in connection with Fig. 1 to 3 relating to the arrangement, fixing and embedding of the power electronics component 8, the arrangement and function of the printed circuit board 2, the housing 1 and its cooling, and the special construction of the plug connection can naturally also be transferred to the embodiment of Fig. 4.

The embodiment is not limited to the embodiment illustrated. It is quite conceivable and possible to accommodate in one housing multiple power modules and power electronics components, which are connected to printed circuit boards in the manner according to the invention. Also, more than two printed circuit boards can be assigned to a power module. These can bound one another with their contours in the region above the power module in the manner of a puzzle, which means an optimal plug assignment can be obtained. It is also conceivable to combine the described connector mechanisms as desired, wherein multiple printed circuit boards, power modules and/or power electronics components can also be electrically connected in different ways. The arrangement of the individual parts can thereby be adapted to the design of the housing or of the vehicle component. Such a possibility is discussed below:

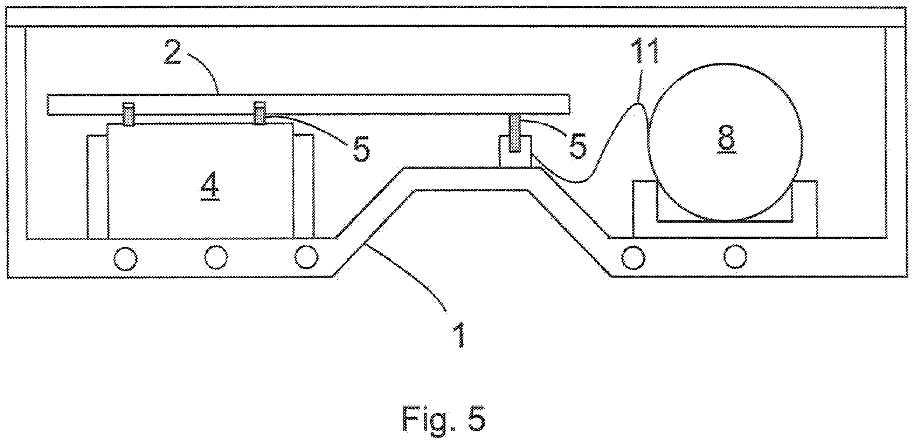

Fig. 5 shows a further embodiment, in which the connector mechanisms of both Fig. 1 to 3 and that of Fig. 4 are combined with one another. The printed circuit board 2 is electrically connected to the power module 4 by means of a direct plug connection 5, as described in relation to Figs. 1 to 3. With the inductive power electronics component 8, the printed circuit board 2 is connected via a further plug connection 5, wherein the one set of connector parts sit directly on the printed circuit board 2 and the other connector parts are internally fixed to the housing 1 and pass into a connection cable 11 leading to the power electronics component 8. Such a combination solution can be realised in an elegant and space-saving manner in particular when the housing comprises a recess, so that the difference in level between the power module 4 and the connector part seated on the housing is small. An alternative solution results when the power module 4 and the connector part seated on the housing are not fixed to the same housing wall.

### List of reference marks

1 - housing
2 - printed circuit board
3 - printed circuit board
4 - power module
5 - plug connection
5a - connector part
5b - connector part
6 - electronic component
7 - connection cable
8 - power electronics component
9-gap
10 - plug connection
11 - connection cable
12 - Side walls

## Claims

1. A power electronic vehicle component, such as an on-board charging device, a converter or a voltage converter for electric or hybrid vehicles, having a housing (1), which is preferably liquid cooled, and in which at least one power electronics component (8), in particular in the form of an inductive component, such as a coil, choke or transformer, and at least one printed circuit board (2, 3) electrically communicating with the power electronics component (8) are accommodated, whereby the printed circuit board (2, 3) is electrically connected to the power electronics component (8) via at least one plug connection (5), which is formed by connector parts (5a, 5b) of male and female type that are pressed into one another and form a press-fit connection, wherein one of the connector parts (5a) sits directly on the printed circuit board (2, 3), **characterized in that** the other connector part (5b) is directly mounted to the wall of the housing and connected to the power electronics component (8) via a connection cable (11).

2. The power electronic vehicle component according to Claim 1, **characterized in that** the male connector part (5a) is essentially perpendicular to the plane of the printed circuit board (2, 3) and is preferably seated directly on the printed circuit board (2, 3).

3. The power electronic vehicle component according to one of the preceding claims, **characterized in that** the connector part (5b), which is fixed to the housing (1), is glued or screwed onto the housing (1).

4. The power electronic vehicle component according to one of the preceding claims, **characterized in that** the plug connection (5) is made in the form of connector strips which comprise multiple contacts.

5. The power electronic vehicle component according to one of the preceding claims, **characterized in that** the power electronics component (8) is fixed onto the housing (1), preferably sitting on the same wall of the housing (1) as the connector part (5b).

6. The power electronic vehicle component according to Claim 5, **characterized in that** the power electronics component (8) sits in a cut-out with side walls that project into the interior of the housing and is preferably glued therein.

7. The power electronic vehicle component according to Claim 5, **characterized in that** the power electronics component (8) is accommodated in a pocket formed integrally with the housing (1) and is preferably embedded in the pocket with glue.

8. The power electronic vehicle component according to one of the preceding claims, **characterized in that** the printed circuit board (2, 3) is electrically connected to a further electronic element (4, 8) via at least one plug connection (5), which is formed by connector parts (5a, 5b) of male and female type that can be pressed into one another, wherein one of the connector parts (5a) sits directly on the printed circuit board (2, 3).

9. The power electronic vehicle component according to claim 8, **characterized in that** the further electronic element is a power module (4) and that the other connector part (5b) of the plug connection (5), which connects the printed circuit board (2, 3) and the power module (4), sits directly on the power module (4), which is preferably fixed to the housing (1), preferably abutting thereto in a planar manner.

10. The power electronic vehicle component according claim 8, **characterized in that** the further electronic element is a further power electronics component (8) and that the other connector part (5b) of the plug connection (5), which connects the printed circuit board (2, 3) and the further power electronics component (8), is fixed to the housing (1) and connected to the further power electronics component (8) via a connection cable (11).

11. The power electronic vehicle component according to one of the preceding claims, **characterized in that** at least one power electronics component (8) is an inductive component, such as a coil, choke or transformer.

12. The power electronic vehicle component according to one of the preceding claims, **characterized in that** a strand of the power electronics component (8) is used as connection cable (11) connecting the power electronics component (8) with the connector part (5b).

13. The power electronic vehicle component according to one of the claims 10 to 12, **characterized in that** the power electronics components (8) are spaced from one another.

14. The power electronic vehicle component according to one of the claims 9 to 13, **characterized in that** the connector parts (5b) of the power electronics components (8) are spaced from one another.

15. An electric or hybrid vehicle, **characterized in that** said vehicle comprises a power electronic vehicle component according to one of the preceding claims.

## Patentansprüche

1. Eine Leistungselektronikkomponente für ein Fahrzeug, wie eine On-Board Ladeeinrichtung, ein Wandler oder ein Spannungswandler für ein Elektro- oder Hybridfahrzeug, aufweisend ein Gehäuse (1), welches bevorzugt flüssigkeitsgekühlt ist, und in welchem zumindest eine Leistungselektronikkomponente (8), insbesondere in der Form einer induktiven Komponente, wie einer Spule, Drossel oder eines Transformators, und zumindest eine Platine (2, 3) untergebracht sind, welche mit der Leistungselektronikkomponente (8) elektrisch in Verbindung steht,
wobei die Platine (2, 3) mit der Leistungselektronikkomponente (8) über zumindest eine Steckverbindung (5) elektrisch verbunden ist, welche von Verbinderteilen (5a, 5b) des männlichen und weiblichen Typs gebildet wird, welche ineinander gepresst werden und eine Presssitz-Verbindung bilden, wobei eines der Verbinderteile (5a) direkt auf der Platine (2, 3) sitzt
**dadurch gekennzeichnet, dass**
das andere Verbinderteil (5b) direkt an der Wand des Gehäuses befestigt und mit der Leistungselektronikkomponente (8) über ein Verbindungskabel (11) verbunden ist.

2. Die Leistungselektronikkomponente für ein Fahrzeug nach Anspruch 1,
**dadurch gekennzeichnet, dass** das männliche Verbinderteil (5a) im Wesentlichen senkrecht zu der Ebene der Platine (2, 3) ist und bevorzugt direkt in der Platine (2, 3) sitzt.

3. Die Leistungselektronikkomponente für ein Fahrzeug nach einem der vorausgehenden Ansprüchen, **dadurch gekennzeichnet, dass** das Verbinderteil (5b), welches an dem Gehäuse (1) befestigt ist, an das Gehäuse (1) geklebt oder geschraubt ist.

4. Die Leistungselektronikkomponente für ein Fahrzeug nach einem der vorausgehenden Ansprüchen, **dadurch gekennzeichnet, dass** die Steckverbindung (5) in der Form von Verbindungsstreifen gefertigt ist, welche mehrere Kontakte aufweisen.

5. Die Leistungselektronikkomponente für ein Fahrzeug nach einem der vorausgehenden Ansprüchen, **dadurch gekennzeichnet, dass** die Leistungselektronikkomponente (8) an dem Gehäuse (1) befestigt ist, bevorzugt indem sie an der selben Wand des Gehäuses (1) sitzt, wie das Verbinderteil (5b).

6. Die Leistungselektronikkomponente für ein Fahrzeug nach Anspruch 5,
**dadurch gekennzeichnet, dass** die Leistungselektronikkomponente (8) in einem Ausschnitt mit Seitenwänden sitzt, welche in das Innere des Gehäuses ragen und bevorzugt darin eingeklebt ist.

7. Die Leistungselektronikkomponente für ein Fahrzeug nach Anspruch 5,
**dadurch gekennzeichnet, dass** die Leistungselektronikkomponente (8) in einer Tasche untergebracht ist, welche integral mit dem Gehäuse (1) gebildet wird und bevorzugt in der Tasche mit Kleber eingebettet ist.

8. Die Leistungselektronikkomponente für ein Fahrzeug nach einem der vorausgehenden Ansprüchen, **dadurch gekennzeichnet, dass** die Platine (2, 3) elektrisch mit einem weiteren elektronischen Element über zumindest eine Steckverbindung (5) verbunden ist, welche von Verbinderteilen (5a, 5b) des männlichen und weiblichen Typs gebildet wird, welche ineinander gepresst werden können, wobei eines der Verbinderteile (5a) direkt auf der Platine (2, 3) sitzt.

9. Die Leistungselektronikkomponente für ein Fahrzeug nach Anspruch 8,
**dadurch gekennzeichnet, dass** das weitere elektronische Element ein Leistungsmodul (4) ist und dass das andere Verbinderteil (5b) der Steckverbindung (5), welche die Platine (2, 3) und das das Leistungsmodul (4) verbindet, direkt auf dem Leistungsmodul (4) sitzt, welches bevorzugt an dem Gehäuse (1) befestigt ist, bevorzugt daran in einer ebenen Art und Weise angrenzend.

10. Die Leistungselektronikkomponente für ein Fahrzeug nach Anspruch 8,
**dadurch gekennzeichnet, dass** das weitere elektronische Element eine weitere Leistungselektronikkomponente (8) ist und dass das andere Verbinderteil (5b) der Steckverbindung (5), welche die Platine (2, 3) und die weitere Leistungselektronikkomponente (8) verbindet, an dem Gehäuse (1) befestigt ist und mit der weiteren Leistungselektronikkomponente (8) über ein Verbindungskabel (11) verbunden ist.

11. Die Leistungselektronikkomponente für ein Fahrzeug nach einem der vorausgehenden Ansprüchen, **dadurch gekennzeichnet, dass** zumindest eine Leistungselektronikkomponente (8) eine induktive Komponente ist, wie eine Spule, Drossel oder ein Transformator.

12. Die Leistungselektronikkomponente für ein Fahrzeug nach einem der vorausgehenden Ansprüchen, **dadurch gekennzeichnet, dass** ein Strang der Leistungselektronikkomponente (8) als Verbindungskabel (11) genutzt wird, um die Leistungselektronikkomponente (8) mit dem Verbinderteil (5b) zu verbinden.

13. Die Leistungselektronikkomponente für ein Fahrzeug nach einem der Ansprüche 10 bis 12, **dadurch gekennzeichnet, dass** die Leistungselektronikkomponenten (8) voneinander beabstandet sind.

14. Die Leistungselektronikkomponente für ein Fahrzeug nach einem der Ansprüche 9 bis 13, **dadurch gekennzeichnet, dass** die Verbinderteile (5b) der Leistungselektronikkomponenten (8) voneinander beabstandet sind.

15. Ein Elektro- oder Hybridfahrzeug, **dadurch gekennzeichnet, dass** das Fahrzeug eine Leistungselektronikkomponente für ein Fahrzeug nach einem der vorausgehenden Ansprüche aufweist.

## Revendications

1. Composant électronique de puissance pour véhicule tel que dispositif de chargement embarqué, convertisseur ou convertisseur de tension pour véhicules électriques ou hybrides, comportant un boîtier (1) qui est refroidi de préférence au liquide et dans lequel au moins un composant électronique de puissance (8), se présentant en particulier sous la forme d'un composant inductif tel qu'une bobine, une bobine d'impédance ou un transformateur, et au moins un circuit imprimé (2, 3) communiquant au niveau électrique avec le composant électronique de puissance (8) sont logés, le circuit imprimé (2, 3) étant connecté électriquement au composant électronique de puissance (8) via au moins une connexion par branchement (5) qui est constituée par des pièces de connexion (5a, 5b) de type mâle et femelle qui sont enfoncés l'une dans l'autre et forment une connexion ajustée à la presse, une des pièces de connexion (5a) étant directement assise sur le circuit imprimé (2, 3),
**caractérisé en ce que** l'autre pièce de connexion (5b) est montée directement sur la paroi du boîtier et connectée au composant électronique de puissance (8) via un câble de connexion (11).

2. Composant électronique de puissance pour véhicule selon la revendication 1, **caractérisé en ce que** la pièce de connexion mâle (5a) est sensiblement perpendiculaire au plan du circuit imprimé (2, 3) et de préférence assise directement sur le circuit imprimé (2, 3).

3. Composant électronique de puissance pour véhicule selon une des revendications précédentes, **caractérisé en ce que** la pièce de connexion (5b) qui est fixée boîtier (1) est collée ou vissée sur le boîtier (1).

4. Composant électronique de puissance pour véhicule selon une des revendications précédentes, **caractérisé en ce que** la connexion par branchement (5) est réalisée sous la forme de bandes de connexion qui comprennent des contacts multiples.

5. Composant électronique de puissance pour véhicule selon une des revendications précédentes, **caractérisé en ce que** le composant électronique de puissance (8) est fixé sur le boîtier (1), de préférence assis sur la même paroi du boîtier (1) que la pièce de connexion (5b).

6. Composant électronique de puissance pour véhicule selon la revendication 5, **caractérisé en ce que** le composant électronique de puissance (8) est assis dans une découpe avec des parois latérales qui sont en saillie dans l'intérieur du boîtier et est de préférence collé dedans.

7. Composant électronique de puissance pour véhicule selon la revendication 5, **caractérisé en ce que** le composant électronique de puissance (8) est logé dans une poche faisant partie intégrante du boîtier (1) et de préférence encastré dans la poche avec de la colle.

8. Composant électronique de puissance pour véhicule selon une des revendications précédentes, **caractérisé en ce que** le circuit imprimé (2, 3) est connecté électriquement à un autre élément électronique (4, 8) via au moins une connexion par branchement (5) qui est constituée par des pièces de connexion (5a, 5b) de type mâles et femelle qui peuvent être enfoncées l'une dans l'autre, une des pièces de connexion (5a) étant assise directement sur le circuit imprimé (2, 3).

9. Composant électronique de puissance pour véhicule selon la revendication 8, **caractérisé en ce que** l'autre élément électronique est un module de puissance (4) et que l'autre pièce de connexion (5b) de la connexion par branchement (5), qui connecte le circuit imprimé (2, 3) et le module de puissance (4), est assise directement sur le module de puissance (4) qui est de préférence fixé au boîtier (1), de préférence en butée contre celui-ci, de manière planaire.

10. Composant électronique de puissance pour véhicule selon la revendication 8, **caractérisé en ce que** l'autre élément électronique est un autre composant électronique de puissance (8) et que l'autre pièce de connexion (5b) de la connexion par branchement (5), qui connecte le circuit imprimé (2, 3) et l'autre composant électronique de puissance (8), est fixée au boîtier (1) et connectée à l'autre composant électronique de puissance (8) via un câble de connexion (11).

11. Composant électronique de puissance pour véhicule selon une des revendications précédentes, **caractérisé en ce qu'**au moins un composant électronique de puissance (8) est un composant inductif tel qu'une bobine, une bobine d'impédance ou un transformateur.

12. Composant électronique de puissance pour véhicule selon une des revendications précédentes, **caractérisé en ce que** le brin du composant électronique de puissance (8) est utilisé comme câble de connexion (11) connectant le composant électronique de puissance (8) à la pièce de connexion (5b).

13. Composant électronique de puissance pour véhicule selon une des revendications 10 à 12, **caractérisé en ce que** les composants électroniques de puissance (8) sont espacés les uns des autres.

14. Composant électronique de puissance pour véhicule selon une des revendications 9 à 13, **caractérisé en ce que** les pièces de connexion (5b) des composants électroniques de puissance (8) sont espacées les unes des autres.

15. Véhicules électriques ou hybrides, **caractérisé en ce que** ledit véhicule comprend un composant électronique de puissance selon une des revendications précédentes.
